# EUROPEAN PATENT SPECIFICATION

(11) **EP 3 556 782 B1**
(45) Date of publication and mention of the grant of the patent: **06.08.2025**
(21) Application number: 18742317.3
(22) Date of filing: 16.01.2018
(51) Int. Cl.: C08F 20/22, H01B 3/44, C09D 133/16, H01L 21/28, C08F 120/24, C08F 220/24

(54) **NOVEL FERROELECTRIC MATERIAL**
NEUARTIGES FERROELEKTRISCHES MATERIAL
NOUVEAU MATÉRIAU FERROÉLECTRIQUE

(30) Priority: 17.01.2017 JP 2017006193
(43) Date of publication of application: 23.10.2019
(73) Proprietor: The School Corporation Kansai University, Suita-shi, Osaka 564-8680 (JP); Osaka Organic Chemical Industry Co., Ltd., Osaka-shi, Osaka 541-0052 (JP)
(72) Inventor: KABATA, Masayuki, Kashiwara-shi Osaka 582-0020 (JP); MANAI, Daisuke, Kashiwara-shi Osaka 582-0020 (JP); TAJITSU, Yoshiro, Suita-shi Osaka 564-8680 (JP)
(74) Representative: Isarpatent
(86) International application number: PCT/JP2018/000910
(87) International publication number: WO 2018/135457

(56) References cited:
- EP-A1- 2 586 805
- EP-A2- 0 336 372
- EP-A2- 0 390 571
- JP-A- 2011 084 648
- JP-A- 2015 180 723
- JP-A- 2016 130 849
- JP-A- 2016 204 533
- JP-A- 2016 204 533
- KE YANG ET AL: "Fluoro-Polymer@BaTiO 3 Hybrid Nanoparticles Prepared via RAFT Polymerization: Toward Ferroelectric Polymer Nanocomposites with High Dielectric Constant and Low Dielectric Loss for Energy Storage Application", CHEMISTRY OF MATERIALS, vol. 25, no. 11, 23 May 2013 (2013-05-23), pages 2327 - 2338, XP055712509, ISSN: 0897-4756, DOI: 10.1021/cm4010486

## Description

### TECHNICAL FIELD

The present invention relates to the use of a (meth)acrylate polymer for an organic ferroelectric material, and to an organic ferroelectric material based thereon.

### BACKGROUND ART

Ferroelectric materials generally possess a piezoelectric property, and it is understood that the greater their remanent polarization is, the more enhanced piezoelectric property they exhibit. So far, organic piezoelectric materials have been represented by those based on polyvinylidene fluoride (PVDF). Piezoelectric materials made of polyvinylidene fluoride have been utilized in the form of a film for various applications such as touch sensors, strain gauges, ultrasonic sensors, transducers, acceleration sensors, vibration sensors, microphones, speakers, and the like. For example, EP 0 390 571 A2 discloses an organic thin film display element comprising an elctrode including a layer comprising a ferroelectric polymer.

Following their synthesis, conventional polymers for organic piezoelectric materials, which are represented by polyvinylidene fluoride, are made into a film form, then subjected to a drawing process which gives their tangled polymer chains containing crystallized portions a certain orientation, and by exposure to a voltage between their opposing surfaces so as to orient the dipoles in the molecules, obtain piezoelectric property. Thus, a process of drawing a polymers is indispensable for producing conventional organic piezoelectric materials, imposing a problem of increased cost for producing organic piezoelectric materials due to installation of drawing equipment and running processes of drawing. Further, drawing creates significant fluctuations in film thickness, which get less controllable as the thickness of the film is reduced, and thus in particular, it is extraordinarily difficult to produce an extremely thin film having thickness levels of several hundred nm by means of drawing. Moreover, as polyvinylidene fluoride is solvent resistant, the solution processing that is widely employed in other areas cannot be used in which a film is formed by thinly applying a polymer solution on a substrate. Thus, there have been particular obstacles in production of organic piezoelectric materials in the form of a thin polymer film. Still further, as it is poorly transparent, there is also a problem that polyvinylidene fluoride cannot by employed in an application where high transparency is required. In addition, another problem with conventional organic piezoelectric materials is that they exhibit lower piezoelectric property than inorganic piezoelectric materials, and therefore improvement in their piezoelectric property has been needed.

### SUMMARY OF INVENTION

### TECHNICAL PROBLEM

Against the above-mentioned background, an objective of the present invention is to provide a polymer for novel organic ferroelectric material. Another objective of the present invention is to provide a polymer for organic ferroelectric material that can be given a ferroelectric property without undergoing drawing. Another objective of the present invention is to provide a polymer for organic ferroelectric material that can be applied as a solution to form a film. Still another objective of the present invention is to provide an organic ferroelectric material having high transparency. An additional objective of the present invention is to provide an organic ferroelectric material having a good ferroelectric property compared with conventional organic ferroelectric materials.

### SOLUTION TO PROBLEM

In a study conducted to achieve the above objectives, the present inventors happened to find out that a material having a large remanent polarization can be obtained using certain kinds of (meth)acrylate polymers without subjecting them to a drawing process. The present invention was completed through additional studies carried out on the basis of this discovery. The present invention is defined by the appended claims.

### EFFECTS OF INVENTION

As the polymer for organic ferroelectric material according to the present invention does not require a drawing process, which is indispensable for conventional organic materials such as polyvinylidene fluoride in order to give them ferroelectric property, it enables improvement in production efficiency through elimination of the process. Further, unlike polyvinylidene fluoride, it can be applied to an object such as a substrate as a solution prepared with a solvent, and thus enables use of spin coating when needed. Thus, as it enables film formation with precisely controlled thickness, it can be advantageously utilized in building various devices, such as sensors, with which high levels of precision is required. Furthermore, as the polymer for organic ferroelectric material according to the present invention and organic ferroelectric materials prepared therewith have high transparency, they can be used in applications that require such a high transparency as cannot be met by polyvinylidene fluoride. Moreover, as they have a remanent polarization that is comparable to or greater than that of polyvinylidene fluoride, they are very likely to exhibit high piezoelectric property compared with conventional organic ferroelectric materials. Thus, it is considered that they can be utilized in wider range of applications.

### DESCRIPTION OF EMBODIMENTS

In the present invention, the term "polymer for organic ferroelectric material" means an organic polymer having a capacity to obtain a ferroelectric property when subjected to a physical processing of exposure to a voltage.

In the present invention, the term "(meth)acrylate" means acrylate and methacrylate alike.

The (meth)acrylate monomer unit (herein also referred to as "main monomer unit"), which is included as an essential component for the polymer of the present invention to be able to obtain ferroelectric property, has in its side chain a saturated or unsaturated hydrocarbon skeleton linked to the distal end of the oxycarbonyl group; and the hydrocarbon skeleton has at least one hydrogen atom on the β-carbon atom and one or more electron-withdrawing groups selected from the group consisting of halogen atom, cyano group, oxo group, and nitro group, that bind to the β-carbon atom and/or to one or more carbon atoms distal thereto, substituting hydrogen atoms thereon, in which the halogen is selected from fluorine atom and chlorine atom. Among these halogen atoms, fluorine atom is preferred.

In the present invention, the term "β-carbon atom" means the carbon atom that locates on the hydrocarbon skeleton moiety which is linked to the oxycarbonyl group "-C(O)O-" contained in the side chain on its oxygen atom side, at the second carbon atom counted from the oxygen atom side.

In the present invention, the saturated or unsaturated hydrocarbon skeleton moiety, which is linked to the oxycarbonyl group "-C(O)O-" on its oxygen atom side in the side chain of the main monomer unit, may be linear, branched, cyclic, or in the form of a combination of such structures, among which a cyclic structure portion may be saturated or an aromatic ring. The number of carbon atoms forming the hydrocarbon skeleton is preferably 2-20, more preferably 2-15, still more preferably 2-10, even more preferably 2-7, and particularly preferably 3-5. The hydrocarbon skeleton moiety may, for example, be, ethyl, propyl, isopropyl, butyl, isobutyl, 1-methylpropyl, pentyl, hexyl, 1-methylpentyl, 1-methylhexyl, 4-methylcyclohexyl, and tolyl, though not limited to these.

Insofar as it has at least one hydrogen atom, the β-carbon atom may, in accordance with the number of remaining hydrogen atoms, have all or part of the rest of its hydrogen atoms substituted by some of the electron withdrawing groups mentioned above. Further, the electron withdrawing groups may substitute all or part of hydrogen atoms on each carbon atom locating on the distal side to the β-carbon atom in the side chain.

. In the present invention, although there is no particular upper limit to the molecular weight of monomers corresponding to the main monomer units, it is preferably not more than 500, more preferably not more than 300, and still more preferably not more than 250.

The polymer for organic ferroelectric material of the present invention may comprise one or more main monomer units.

Further, the polymer for organic ferroelectric material of the present invention may, in addition to main monomer, further comprise one or more other kinds of (meth)acrylate monomer units. In the case where the polymer for organic ferroelectric material of the present invention comprises such additional (meth)acrylate monomer units, the molar ratio of the main monomer units to all the (meth)acrylate monomer units is preferably not less than 80%, more preferably not less than 85%, still more preferably not less than 90%, and particularly preferably not less than 95%. In such cases, the other (meth)acrylate monomer units than the main monomer units can be utilized as desired to adjust the properties (mechanical, electric, or chemical) of the polymer of the present invention. Examples of such additional (meth)acrylate monomers for adjustment particularly include, but are not limited to, C1-C4 alkyl (meth)acrylates such as methyl (meth)acrylate, ethyl (meth)acrylate, methyl 2-halo(meth)acrylate, ethyl 2-halo(meth)acrylate, wherein the halogen may be fluorine or chlorine, propyl (meth)acrylate, isopropyl (meth)acrylate, n-butyl (meth)acrylate, isobutyl (meth)acrylate, t-butyl (meth)acrylate, and the like, and also include, for example, neopentyl (meth)acrylate, ethoxyethoxyethyl (meth)acrylate, hydroxy C1-C4 alkyl (meth)acrylates, methoxy C1-C4 alkyl (meth)acrylate, and benzyl (meth)acrylate.

In the present invention, the term "(meth)acrylate polymer" means a homopolymer and a copolymer which are composed mainly of acrylate monomer units and/or methacrylate monomer units. The phrase "composed mainly of" means that (meth)acrylate monomer units (main monomer units and (meth)acrylate monomer units for adjustment) make up, in molar percent, preferably not less than 90%, more preferably not less than 95%, and particularly preferably not less than 98%, e.g. 100%, of the polymer for organic ferroelectric material of the present invention. Monomer units making up the other part than the (meth)acrylate monomer units may be utilized as desired to adjust the properties (mechanical, electric, or chemical) of the polymer of the present invention. Examples of such non-(meth)acrylate monomer units for adjustment include, but are not limited to, monomers having an ethylenic double bond, such as vinyl acetate, acrylic acid, methacrylic acid, N-methyl(meth)acrylamide, N-ethyl(meth)acrylamide, N-propyl-(meth)acrylamide, N-isopropyl(meth)acrylamide, N-butoxymethyl(meth)acrylamide, N-t-butyl(meth)acrylamide, N-octyl(meth)acrylamide, N,N-dimethyl(meth)acrylamide, N,N-diethyl(meth)acrylamide, (meth)acryloylmorpholine, diacetone(meth)acrylamide, (meth)acrylonitrile, phenylacrylonitrile, styrene, α-methylstyrene, p-hydroxystyrene, methyl itaconate, ethyl itaconate, vinyl propionate, N-vinylpyrrolidone, N-vinylcaprolactam, N-phenylmaleimide, and the like.

The mean molecular weight of the polymer for organic ferroelectric material of the present invention is in the range of 10,000-500,000. It may be set as desired, e.g., in the range of 100,000-400,000, in the range of 200,000-300,000, and the like. Besides, the term "mean molecular weight" as used with the polymer of the present invention means weight-average molecular weight, which can be determined using gel filtration column chromatography.

Examples of main monomers that may form the polymer for organic ferroelectric material of the present invention include, but are not limited to, 3,3,3-trifluoropropyl (meth)acrylate, 3,3,3-trichloropropyl (meth)acrylate, 4,4,4-trifluorobutyl (meth)acrylate, 4,4,4-trichlorobutyl (meth)acrylate, 2,2-difluoroethyl (meth)acrylate, 2,2-dichloroethyl (meth)acrylate, 2-cyanoethyl (meth)acrylate, 4-(trifluoromethyl)cyclohexyl (meth)acrylate, and 4-(trichloromethyl)cyclohexyl (meth)acrylate.

The polymer for organic ferroelectric material of the present invention can be produced using some of the main monomers mentioned above and by the well-known method for production of poly(meth)acrylate polymers. For polymerization of monomer components, one or more conventional polymerization initiators are preferably employed following a common procedure. Examples of such polymerization initiators include 2,2'-azobisisobutyronitrile, azoisobutyronitrile, azobisdimethylvaleronitrile, benzoyl peroxide, potassium persulfate, ammonium persulfate, benzophenone derivatives, phosphine oxide derivatives, benzoketone derivatives, phenyl thioether derivatives, azide derivatives, diazo derivatives, disulfide derivatives, and the like, of which two or more may be employed together as desired.

Further, in the case where some of the monomers that make up the polymer for organic ferroelectric material mentioned above have a functional group which is not directly involved in the polymerization reaction in the process of polymer formation, the polymer may be provided in a cross-linked form with a proper cross-linking agent that can form a covalent bond by reaction with the functional group. Examples of such functional groups include hydroxyl group, amino group, isocyanate group, and the like.

Specific examples of such monomers having a hydroxyl group include, but are not limited to, 2-hydroxyethyl (meth)acrylate, 2-hydroxypropyl (meth)acrylate, 2-hydroxybutyl (meth)acrylate, 2-hydroxy-1-methylethyl (meth)acrylate, 4-hydroxybutyl (meth)acrylate, 4-hydroxyphenyl (meth)acrylate, 4-hydroxycyclohexyl (meth)acrylate, 1,4-cyclohexane dimethanol (meth)acrylate, 2-hydroxy-3-phenoxypropyl (meth)acrylate, dipentaerythritol penta(meth)acrylate, and polypropylene glycol (meth)acrylate.

Further, specific examples of such monomers having an isocyanate group include, but are not limited to, 2-isocyanatoethyl (meth)acrylate, 3-isocyanatopropyl (meth)acrylate, 2-isocyanato-1-methylethyl (meth)acrylate, 2-(ethoxycarboxyamino)-ethyl (meth)acrylate, 2-butoxy carboxyamino)ethyl (meth)acrylate, 2-(isopropoxy-carboxyamino)ethyl (meth)acrylate, 2-([1-methoxy-2-propoxy]carboxyamino)ethyl (meth)acrylate, and 2-([1-methylpropylideneamino]carboxyamino)ethyl (meth)-acrylate.

Examples of cross-linking agents usable for polymers containing monomer units having a hydroxyl group include those having two or more isocyanate groups. Specific examples of such cross-linking agents include, but are not limited to, 1,6-hexane diisocyanate, 2,2,4-trimethylhexamethylene diisocyanate, 2-methylpentane-1,5-diyl bisisocyanate, 2,4-tolylene diisocyanate, 2,6-tolylene diisocyanate, 1,3-phenylene diisocyanate, 1,4-phenylene diisocyanate, 1,3-xylylene diisocyanate, 1,4-xylylene diisocyanate, 1,5-naphthalene diisocyanate, 3,3'-dimethyl-4,4'-diphenylmethane diisocyanate, 4,4'-diphenylmethane diisocyanate, 3,3'-dimethylphenylene diisocyanate, 4,4'-biphenylene diisocyanate, isophorone diisocyanate, methylenebis(4-cyclohexyl isocyanate), bis(2-isocyanatoethyl) fumarate, 6-isopropyl-1,3-phenyl diisocyanate, 4,4'-diphenylpropane diisocyanate, lysine diisocyanate, 1,3-bis(isocyanatomethyl)cyclohexane, tetramethylxylylene diisocyanate, [(bicyclo[2.2.1]heptane-2,5-diyl)bismethylene] bisisocyanate, 1,3,5-tris-(6-isocyanatohexyl)-1,3,5-triazine-2,4,6-(1H, 3H, 5H)-trione, methyltriisocyanatosilane, and tetraisocyanatosilane.

Furthermore, as a cross-linking agent for a polymer that contains monomer units having an isocyanate group, one of those compounds which have 2 or more hydroxyl groups or 2 or more amino groups, for example, can be employed. Specific examples of such a cross-linking agent include, but are not limited to, ethylene glycol, propylene glycol, 1,3-propanediol, 1,3-butane diol, 1,4-butanediol, 1,5-pentanediol, 1,6-hexanediol, 1,8-octanediol, 1,9-nonanediol, diethylene glycol, dipropylene glycol, neopentyl glycol, glycerol, pentaerythritol, 1,1,1-trimethylolpropane, 1,2,5-hexanetriol, 1,4-cyclohexanediol, hydroquinone, 4,4'-dihydroxyphenylmethane, 2,2-bis(4-hydroxyphenyl)propane, polypropylene glycol, polyoxyethylene glycol, polyoxypropylenetriol, polyoxypropylene and glycol; and trimethylenediamine, hexamethylenediamine, 1,10-aminodecane, ethylene glycol bis(2-aminoethyl)ether, 1,3-bis(aminomethyl)cyclohexane, 1,4-bis(aminomethyl)-cyclohexane, 4,4'-diaminobenzophenone, 3,4'-diaminodiphenyl ether, 4,4'-diaminodiphenyl ether, 3,3'-diaminodiphenylmethane, 4,4'-diaminodiphenylmethane, and 2,7-diaminofluorene.

Cross-linking of the polymer for organic ferroelectric material mentioned above can be carried out by a conventional method in accordance with the combination of the cross-linking agent employed and the functional group that is to take part in the bond formation with the cross-linking agent. For example, to produce a cross-linked polymer in a film form, cross-linking is performed preferably by heating and/or by irradiation with energy beam, such as ultraviolet light, of a cross-linking agent-containing, uncrosslinked polymer prepared in the form of a coating film.

By application of a voltage between the front and back surfaces of it in the form of film, the polymer for organic ferroelectric material of the present invention obtains a large remanent polarization, making an organic ferroelectric material. Unlike polyvinylidene fluoride, it does not need drawing, and can be made into a film form using any one of well-known methods chosen as desired. And as it is not solvent resistant as is polyvinylidene fluoride, the polymer for organic ferroelectric material of the present invention can be prepared into a solution using a proper solvent, which then can be applied to a substrate surface, dried, or further baked, into a film. Furthermore, a thin layer of it can be prepared very easily by applying it on a substrate as a solution and subjecting it to spin coating. Though there is no particular limitation as to the thickness of a film, a thickness of 10-100 µm, for example, is easily achievable, and thus it is applicable to various uses and thus convenient. Application of voltage to a film of the polymer for organic ferroelectric material of the present invention can be carried out by the well-known method employed for polyvinylidene fluoride. The remanent polarization of the organic ferroelectric material of the present invention is at least 100 mC/m².

### EXAMPLES

Though the present invention is described in further detail below with reference to examples, it is not intended that the present invention be limited to the examples. Examples 2, 3 and 6 are reference examples.

### [Example 1] Preparation of Polymer (A) and evaluation of its ferroelectric property

### (1) Synthesis of 3,3,3-trifluoropropyl methacrylate (3FPMA)

Following the procedure shown below, 3FPMA was synthesized.

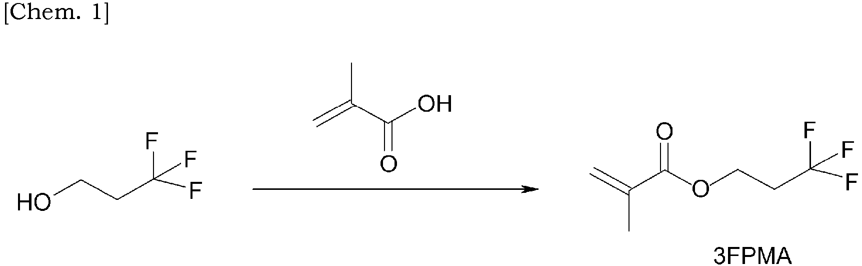

In a 1-L 5 neck glass flask equipped with a reflux condenser, water separator, air intake tube, thermometer and stirrer, 25.0 g of 3,3,3-trifluoropropanol, 18.9 g of methacrylic acid, and 5.36 g of N,N-dimethyl-4-aminopyridine were dissolved in 200 g of dichloroethane, to which was added 44.1 g of 1-(3-dimethylaminopropyl)-3-ethylcarbodiimide hydrochloride with stirring in an ice bath, and stirring was continued for 10 hours. Then, after washing and concentration, purification by distillation under reduced pressure gave 21.9 g of 3,3,3-trifluoropropyl methacrylate (3FPMA) as a clear and colorless liquid (GC purity: 99%, Yield: 55%).
¹H-NMR (CDCl3, ppm): 1.94-1.95 (3H, m), 2.44-2.59 (2H, m), 4.38 (2H, t), 5.58-5.62 (1H, m), 6.13-6.14 (1H, m)

### (2) Synthesis of Polymer (A) (p-3FPMA)

Polymer (A) (p-3FPMA) was produced by polymerizing the 3FPMA synthesized above following the procedure shown below.

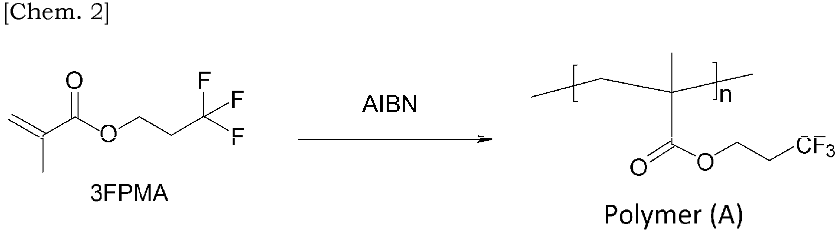

In a 50-mL flask were put 5.0 g of the 3FPMA synthesized above and 12.0 g of butyl acetate. Into the solution thus prepared was introduced nitrogen gas flow for 30 minutes, then the inner temperature was raised up to 78° C, and 0.15 g of 2,2'-azobisisobutyronitrile (AIBN) was added as the reaction initiator. After 6-hour maturation at 80 ± 5 °C, the solution was cooled to 35° C or lower. The polymerization solution thus obtained was dried at 50°C under reduced pressure to give Polymer (A). The weight-average molecular weight (Mw) as determined by gel permeation column chromatography (GPC) was 16,000.

### (3) Film formation

Polymer (A) was dissolved in butyl acetate to prepare a solution (solid content = 55%). This solution was applied to an evaluation substrate equipped with an electrode, which then was accelerated on a spin coater up to 1,000 rpm over one second, and the spinning rate was kept for 10 seconds and then stopped in one second to form a film. The evaluation substrate thus prepared was left undisturbed for 30 seconds, dried on a hot plate for 20 minutes at 100 °C, and cooled to room temperature to give an evaluation substrate provided with a film of Polymer (A). The thickness of the film was 15.1 µm as measured using a stylus profilometry Dektak (mfd. by Bruker).

### (4) Formation of electrode

Gold or aluminum was vacuum vapor deposited on the film of Polymer (A) on the evaluation substrate.

### (5) Application of voltage and evaluation

For poling treatment, alternating voltage with a frequency of 0.001 Hz to 1 Hz was applied to the sample thus prepared using a high voltage apparatus (HEOPS-1B30, mfd. by Matsusada Precision Inc.). Further, the response charge from the sample was measured for hysteresis through a charge amplifier, and the remanent polarization and relative permittivity were determined based on the result of measurement.

The criterium for evaluation of remanent polarization is as follows.
: Remanent polarization not less than 2 times that of PVDF (100 mC/m²)
∘: Remanent polarization not less than, but less than 2 times, that of PVDF (100 mC/m²).
Δ: Remanent polarization less than that of PVDF (100 mC/m²)
×: No remanent polarization

The result is shown in Table 1.

### [Example 2] Preparation of Polymer (B) and evaluation of its ferroelectric property (reference example)

### (1) Synthesis of Polymer (B) (p-3FEMA)

Polymer (B) (p-3FEMA) was synthesized using 2,2,2-trifluoroethyl methacrylate (3FEMA) (Tokyo Chemical Industry Co., Ltd.) as the monomer.

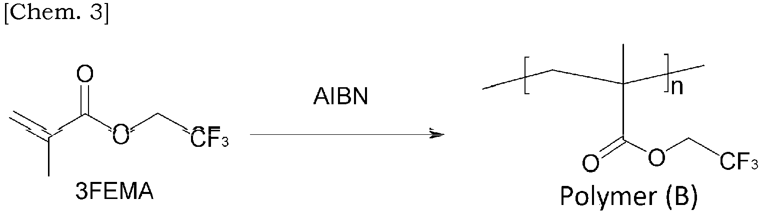

Namely, Polymer (B) (p-3FEMA) was prepared in the same manner as in (2) of Example 1 except that 3FEMA was employed instead of 3FPMA. The mean molecular weight of it was 15,000.

### (2) Film formation

A film was formed on an evaluation substrate following the same procedure as described in (3) of Example 1 except that Polymer (B) was employed instead of Polymer (A). The thickness of the film was 14.8 µm.

### (3) Formation of electrode, application of voltage, and evaluation

Formation of an electrode on Polymer (B), application of a voltage to the polymer, and evaluation of its ferroelectric property were conducted in the same manner as in Example 1. The result is shown in Table 1.

### [Example 3] Preparation of Polymer (C) and evaluation of its ferroelectric property (reference example)

### (1) Synthesis of Polymer (C) (p-6FMA)

Polymer (C) was synthesized using 1,1,1,3,3,3-hexafluoroisopropyl methacrylate (6FMA) (Tokyo Chemical Industry Co., Ltd.) as the monomer.

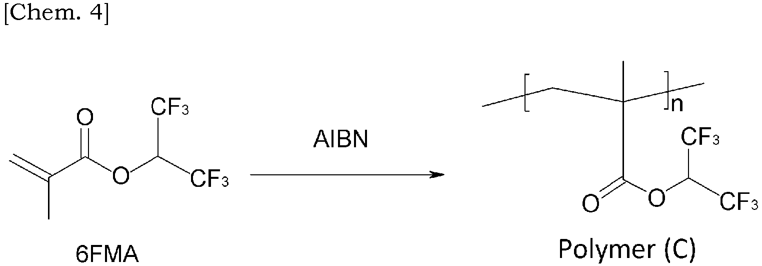

Namely, in a 50-mL flask were put 10.0 g of 6FPMA and 24.0 g of butyl acetate to prepare a solution. Nitrogen gas flow was introduced into this solution for 30 minutes, then the inner temperature was raised up to 78° C, and 0.15 g of AIBN was added as the reaction initiator. After 6-hour maturation, the solution was cooled to 35° C or lower. The polymerization solution thus obtained was dried at 50° C under reduced pressure to give Polymer (C) (p-6FMA). The weight-average molecular weight of this polymer was 5,300 as determined by gel permeation chromatography (GPC).

### (3) Film formation

A film was formed on an evaluation substrate following the same procedure as described in (3) of Example 1 except that Polymer (C) was employed instead of Polymer (A). The thickness of the film was 14.1 µm.

### (4) Formation of electrode, application of voltage, and evaluation

Formation of an electrode on Polymer (C), application of voltage to the polymer, and evaluation of its ferroelectric property were conducted in the same manner as in Example 1. The result is shown in Table 1.

### [Comparative Example] PVDF

Electrodes were prepared on the front and back surfaces of 35-µm thick drawn PVDF film (mfd by Kureha Corporation), and application of a voltage to the polymer and evaluation of its ferroelectric property were conducted in the same manner as in Example 1. The result showed that the ferroelectric property evaluation of 100 mC/m².

### [Example 4] Preparation of Polymer (D) and evaluation of its ferroelectric property

### (1) Synthesis of Polymer (D) (p-3FPMA)

Polymer (D) (p-3FPMA) was synthesized using 3,3,3-trifluoropropyl methacrylate (3FPMA) as the monomer.

Namely, 2.0 g of 3FPMA was put in a glass vessel, and after nitrogen gas bubbling for 30 seconds, 0.02 g of 2,4,6-trimethylbenzoyl-diphenyl-phosphine oxide (product name: IRGACURE TPO, mfd. by BASF) was added as the polymerization initiator, and the vessel was sealed. The monomer component then was irradiated with ultraviolet light at an illumination intensity of 1.0 mW/cm² for two hours for bulk polymerization of the monomer component to give Polymer (D). The weight-average molecular weight (Mw) was 220,000 as determined by gel permeation chromatography (GPC).

### (2) Film formation

A film was formed on an evaluation substrate following the same procedure described in (3) of Example 1 except that Polymer (D) (solid content = 30%) was employed instead of Polymer (A) and that the spinning rate was changed to 700 rpm. The thickness of the film was 13.5 µm.

### (3) Formation of electrode, application of voltage, and evaluation

Formation of an electrode on Polymer (D), application of voltage to the polymer, and evaluation of ferroelectric property were conducted in the same manner as in Example 1. The result is shown in Table 1.

### [Example 5] Preparation of Polymer (E) and evaluation of its ferroelectric property

### (1) Synthesis of Polymer (E) (p-3FPMA)

Polymer (E) (p-3FPMA) was synthesized using 3,3,3-trifluoropropyl methacrylate (3FPMA) as the monomer. Namely, 2.0 g of 3FPMA was put in a glass vessel, and after nitrogen bubbling for 30 seconds, 0.001 g of 2,4,6-trimethylbenzoyl-diphenyl-phosphine oxide (product name: IRGACURE TPO, mfd. by BASF) was added as a polymerization initiator, and the vessel was sealed. The monomer component then was irradiated with ultraviolet light at an illumination intensity of 1.0 mW/cm² for two hours for bulk polymerization of the monomer component to give Polymer (E). The weight-average molecular weight (Mw) of thus obtained polymer was 300,000 as determined by gel permeation chromatography (GPC).

### (2) Film formation

A film was formed on an evaluation substrate following the same procedure as described in (3) of Example 1 except that Polymer (E) (solid content = 30%) was employed instead of Polymer (A) and that the spinning rate was changed to 900 rpm. The thickness of the film was 12.1 µm.

### (3) Formation of electrode, application of voltage, and evaluation

Formation of an electrode on Polymer (E), application of voltage to the polymer, and evaluation of ferroelectric property were conducted in the same manner as in Example 1. The result is shown in Table 1.

### [Example 6] Preparation of Polymer (F) and evaluation of its ferroelectric property (reference example)

### (1) Synthesis of Polymer (F) (p-3FPMA)

Polymer (F) (p-3FPMA) was synthesized using 3,3,3-trifluoropropyl methacrylate (3FPMA) as the monomer.

Namely, 2.0 g of 3FPMA was put in a glass vessel, and after nitrogen bubbling for 30 seconds, 0.001 g of 2,4,6-trimethylbenzoyl-diphenyl-phosphine oxide (product name: IRGACURE TPO, mfd. by BASF) was added as the polymerization initiator, and the vessel was sealed. The monomer component then was irradiated with ultraviolet light at an illumination intensity of 0.5 mW/cm² for two hours for bulk polymerization of the monomer component to give Polymer (F). The weight-average molecular weight (Mw) was 580,000 as determined by gel permeation chromatography (GPC).

### (2) Film formation

A film was formed on an evaluation substrate following the same procedure described in (3) of Example 1 except that Polymer (F) (solid content = 20%) was employed instead of Polymer (A) and that the spinning rate was changed to 700 rpm. The thickness of the film was 12.4 µm.

### (3) Formation of electrode, application of voltage, and evaluation

Formation of an electrode on Polymer (F), application of voltage to the polymer, and evaluation of ferroelectric property were conducted in the same manner as in Example 1. The result is seen in Table 1.

### [Example 7] Preparation of Polymer (G) and evaluation of its ferroelectric property

### (1) Synthesis of Polymer (G) (p-(3FPMA/BA=80/20))

Polymer (G) (p-3FPMA/BA = 80/20) was synthesized using 3,3,3-trifluoropropyl methacrylate (3FPMA) and butyl acrylate (BA) (Tokyo Chemical Industry Co., Ltd.) as the monomers.

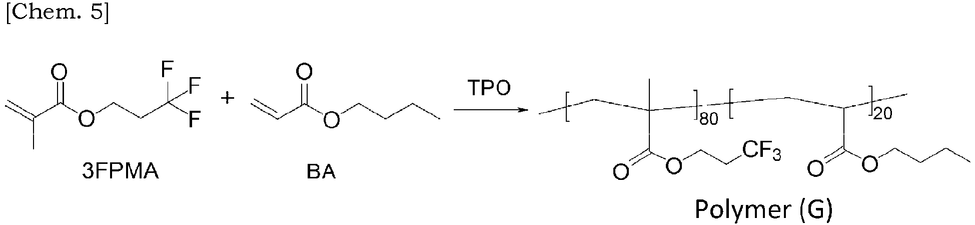

In a glass vessel were put 1.70 g of 3FPMA and 0.30 g of BA, and after nitrogen gas bubbling for 30 seconds, 0.02 g of 2,4,6-trimethylbenzoyl-diphenyl-phosphine oxide (product name: IRGACURE TPO, mfd. by BASF) was added as the polymerization initiator, and the vessel was sealed. The monomer components then were irradiated with ultraviolet light at an illumination intensity of 1.0 mW/cm² for two hours for bulk polymerization of the monomer components to give Polymer (G). The weight-average molecular weight (Mw) was 310,000 as determined by gel permeation chromatography (GPC).

### (2) Film formation

A film was formed on an evaluation substrate following the same procedure as described in (3) of Example 1 except that Polymer (G) (solid content = 30%) was employed instead of Polymer (A) and that the spinning rate was changed to 900 rpm. The thickness of the film was 12.5 µm.

### (3) Formation of electrode, application of voltage, and evaluation

Formation of an electrode on Polymer (G), application of voltage to the polymer, and evaluation of ferroelectric property were conducted in the same manner as in Example 1. The result is shown in Table 1.

### [Example 8] Preparation of Polymer (H) and evaluation of its ferroelectric property

### (1) Synthesis of Polymer (H) (p-(3FPMA/CNEA = 95/5))

Polymer (H) (p-(3FPMA/CNEA = 95/5)) was synthesized using 3,3,3-trifluoropropyl methacrylate (3FPMA) and 2-cyanoethyl acrylate (CNEA) (Tokyo Chemical Industry Co., Ltd.) as the monomers.

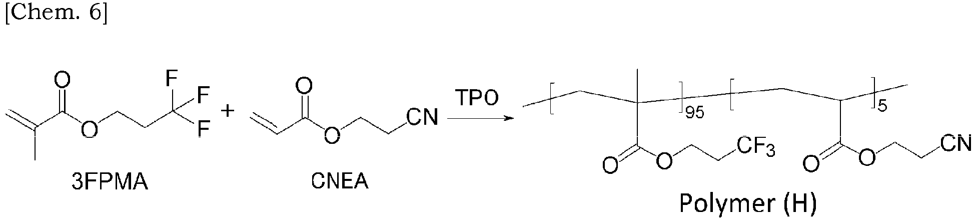

In a glass vessel were put 1.93 g of 3FPMA and 0.07 g of CNEA, and after nitrogen bubbling for 30 seconds, 0.02 g of 2,4,6-trimethylbenzoyl-diphenyl-phosphine oxide (product name: IRGACURE TPO, mfd. by BASF) was added as the polymerization initiator, and the vessel was sealed. The monomer components then were irradiated with ultraviolet light at an illumination intensity of 1.0 mW/cm² for two hours for bulk polymerization of the monomer components to give Polymer (H). The weight-average molecular weight (Mw) was 250,000 as determined by gel permeation chromatography (GPC).

### (2) Film formation

A film was formed on an evaluation substrate following the same procedure as described in (3) of Example 1 except that Polymer (H) was (solid content = 30%) was employed instead of Polymer (A) and that the spinning rate was changed to 700 rpm. The thickness of the film was 13.1 µm.

### (3) Formation of electrode, application of voltage, and evaluation

Formation of an electrode on Polymer (H), application of voltage to the polymer, and evaluation of ferroelectric property were conducted in the same manner as in Example 1. The result is shown in Table 1.

### [Example 9] Preparation of Polymer (I) and evaluation of its ferroelectric property

### (1) Synthesis of Polymer (I) (p-(3FPMA/FMA = 90/ 10))

Polymer (I) (p-3FPMA/FMA = 90/10) was synthesized using 3,3,3-trifluoropropyl methacrylate (3FPMA) and methyl 2-fluoroacrylate (FMA) (mfd. by Alfa Aesar) as the monomers.

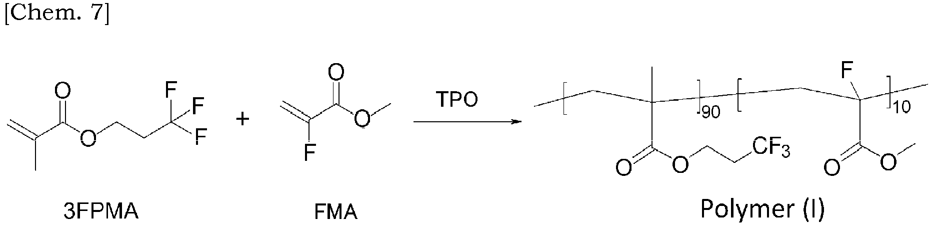

In a glass vessel were put 1.88 g of 3FPMA and 0.12 g of FMA, and after nitrogen bubbling for 30 seconds, 0.02 g of 2,4,6-trimethylbenzoyl-diphenyl-phosphine oxide (product name: IRGACURE TPO, mfd. by BASF) was added as the polymerization initiator, and the vessel was sealed. The monomer components then were irradiated with ultraviolet light at an illumination intensity of 1.0 mW/cm² for two hours for bulk polymerization of the monomer components to give Polymer (I). The weight-average molecular weight (Mw) was 240,000 as determined by gel permeation chromatography (GPC).

### (2) Film formation

A film was formed on an evaluation substrate following the same procedure as described in (3) of Example 1 except that Polymer (I) (solid content = 30%) was employed instead of Polymer (A) and that the spinning rate was changed to 700 rpm. The thickness of the film was 13.3 µm.

### (3) Formation of electrode, application of voltage, and evaluation

Formation of an electrode on Polymer (I), application of voltage to the polymer, and evaluation of ferroelectric property were conducted in the same manner as in Example 1. The result is shown in Table 1.

### [Example 10] Preparation of Polymer (J) and evaluation of its ferroelectric property

### (1) Synthesis of Polymer (J) (p-(3FPMA/HEMA = 99/ 1))

Polymer (J) (p-(3FPMA/HEMA = 99/1)) was synthesized using 3,3,3-trifluoropropyl methacrylate (3FPMA) and hydroxyethyl methacrylate (HEMA) (mfd. by Tokyo Chemical Industry Co., Ltd.) as the monomers.

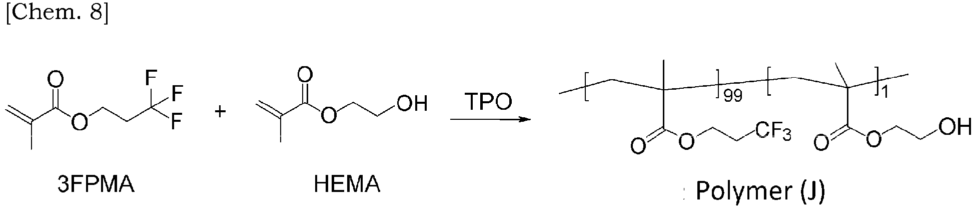

In a glass vessel was put 1.99 g of 3FPMA and 0.01 g of HEMA, and after nitrogen bubbling for 30 seconds, 0.02 g of 2,4,6-trimethylbenzoyl-diphenyl-phosphine oxide (product name: IRGACURE TPO, mfd. by BASF) was added as the polymerization initiator, and the vessel was sealed. The monomer components then were irradiated with ultraviolet light at an illumination intensity of 1.0 mW/cm² for two hours for bulk polymerization of the monomer components to give Polymer (J). The weight-average molecular weight (Mw) was 200,000 as determined by gel permeation chromatography (GPC).

### (2) Film formation

In butyl acetate, 2.0 g Polymer (J) was dissolved to prepare a solution (solid content = 30%). To this solution was added 0.01 g of 1,3-bis(isocyanatomethyl)-cyclohexane (mfd. by Tokyo Chemical Industry Co., Ltd.) as the crosslinking agent and 0.02 mg of catalytic tin (dibutyltin) (product name: Neostann U-100, mfd. by Nitto Kasei Co., Ltd.), and this solution was applied to an evaluation substrate equipped with electrode, which then was accelerated on a spin coater up to 700 rpm over one second, and the spinning rate was kept for 10 seconds and then stopped in one second to form a film. The evaluation substrate thus prepared was left undisturbed for 30 seconds, dried on a hot plate for 3 hours at 100 °C, and cooled to room temperature to give an evaluation substrate provided with a film of crosslinked Polymer (J). The thickness of the film was 12.5 µm as measured using a stylus profilometry Dektak (mfd. by Bruker).

### (3) Formation of electrode, application of voltage, and evaluation

Formation of an electrode on crosslinked Polymer (J), application of voltage to the polymer, and evaluation of its ferroelectric property were conducted in the same manner as in Example 1. The result is shown in Table 1.

Results of ferroelectric property evaluation

The results of ferroelectric property evaluation of the polymers of Examples 1-10 were as follows.

**[Table 1]**

| Table 1. Evaluation ferroelectric property | | |
|---|---|---|
| Polymers | Permittivity | Remanent polarization |
| (A) | 5.88 | ⊚ |
| (B) | 2.64 | × |
| (C) | 2.88 | × |
| (D) | 6.50 | ⊚ |
| (E) | 6.50 | ⊚ |
| (F) | 7.00 | ○ |
| (G) | 6.30 | ○ |
| (H) | 7.90 | ⊚ |
| (I) | 8.00 | ⊚ |
| Crosslinked (J) | 7.00 | ⊚ |

As seen in the table, Polymer (A) shows a high relative permittivity and a remanent polarization not less than twice as high as that of PVDF, and therefore that this polymer is likely to exhibit a superb piezoelectric property. Polymers (D), (E), (H), (I), and crosslinked (J) also exhibit a relative permittivity comparable to that of Polymer (A) and a remanent polarization not less than twice as high as that of PVDF, and thus they also are likely to exhibit a superb piezoelectric property. Besides, Polymers (F) and (G) have a relative permittivity comparable to Polymer (A), and a remanent polarization not less than that of PVDF, and thus these also are likely to have a sufficient piezoelectric property.

### INDUSTRIAL APPLICABILITY

As it does not require drawing, a preliminary process for obtaining ferroelectric property, the polymer for organic ferroelectric material of the present invention enables simplification of the process for production of ferroelectric materials, and easy improvement in production efficiency and cost reduction. Further, that it comes to have a large remanent polarization compared with polyvinylidene fluoride strongly suggests high probability of its achieving superb piezoelectric property. Moreover, as it allows utilization of solution process, and therefore easy achievement of high precision film production, it is highly useful in a wide variety of applications such as sensors, and the like. In particular, as it is highly transparent, it can be applied to such usages for which polyvinylidene fluoride cannot be employed due to its lack or transparency.

## Claims

1. Use of a (meth)acrylate polymer for an organic ferroelectric material, wherein the (meth)acrylate polymer comprises one or more kinds of (meth)acrylates as main monomer units having in the side chain a saturated or unsaturated hydrocarbon skeleton linked to the distal end of the oxycarbonyl group, wherein the hydrocarbon skeleton has
at least one hydrogen atom on the β-carbon atom relative to the oxycarbonyl group, and
one or more electron withdrawing groups selected from the group consisting of halogen atom, cyano group, oxo group, and nitro group, that bind to the β-carbon atom and/or to one or more carbon atoms distal thereto, substituting hydrogen atoms thereon, wherein the halogen atom is selected from fluorine atom and chlorine atom, and said polymer for organic ferroelectric material has a mean molecular weight of 10,000 to 500,000, wherein said mean molecular weight refers to a weight-average molecular weight which is determined using gel filtration column chromatography.

2. The use of a (meth)acrylate polymer according to claim 1, wherein the number of carbon atoms of the hydrocarbon skeleton is 2-20.

3. The use of a (meth)acrylate polymer according to claim 1 or 2, wherein the molecular weight of the (meth)acrylate monomers corresponding to the main monomer units is not more than 500.

4. The use of a (meth)acrylate polymer according to one of claims 1-3, wherein the hydrocarbon skeleton is a saturated hydrocarbon skeleton.

5. The use of a (meth)acrylate polymer according to one of claims 1-4, wherein the (meth)acrylate monomers corresponding to the main monomer units is 3, 3, 3-trifluoropropyl (meth)acrylate or 3, 3, 3-trichloropropyl (meth)acrylate.

6. The use of a (meth)acrylate polymer according to one of claims 1-5, the (meth)acrylate polymer further comprising one or more other kinds of (meth)acrylate monomer units than the main monomer units.

7. The use of a (meth)acrylate polymer according to one of claims 1-6, the (meth)acrylate polymer being in the form of a film.

8. An organic ferroelectric material provided by using the (meth)acrylate polymer for organic ferroelectric material according to claim 7 having a thickness of 10-100 µm, whereby said organic ferroelectric material has a remanent polarization.

9. The organic ferroelectric material according to claim 8 whose remanent polarization is at least 100 mC/m², wherein said remanent polarization is determined by applying an alternating voltage with a frequency of 0.001 Hz to 1 Hz to the organic ferroelectric material and measuring the response charge from the organic ferroelectric material for hysteresis through a charge amplifier.

10. The use of a (meth)acrylate polymer according to one of claims 1-6, wherein the polymer is cross-linked with a cross-linking agent.

11. The use of a (meth)acrylate polymer according to claim 10, wherein the polymer is in the form of a film.

12. An organic ferroelectric material provided by using the polymer for organic ferroelectric material according to claim 11 having a thickness of 10-100 µm, whereby said organic ferroelectric material has a remanent polarization.

13. The organic ferroelectric material according to claim 12 whose remanent polarization is at least 100 mC/m², wherein said remanent polarization is determined by applying an alternating voltage with a frequency of 0.001 Hz to 1 Hz to the organic ferroelectric material and measuring the response charge from the organic ferroelectric material for hysteresis through a charge amplifier.

## Patentansprüche

1. Verwendung eines (Meth)acrylat-Polymers für ein organisches ferroelektrisches Material, wobei das (Meth)acrylat-Polymer eine oder mehrere Arten von (Meth)acrylaten als Hauptmonomereinheiten umfasst, die in der Seitenkette ein gesättigtes oder ungesättigtes Kohlenwasserstoffgerüst aufweisen, das an das distale Ende der Oxycarbonylgruppe gebunden ist, wobei das Kohlenwasserstoffgerüst aufweist:
mindestens ein Wasserstoffatom an dem β-Kohlenstoffatom bezüglich der Oxycarbonylgruppe, und
eine oder mehrere elektronenziehende Gruppen, ausgewählt aus der Gruppe bestehend aus Halogenatom, Cyanogruppe, Oxogruppe und Nitrogruppe, die sich an das β-Kohlenstoffatom und/oder an ein oder mehrere Kohlenstoffatome distal dazu binden, unter Ersetzung von Wasserstoffatomen daran, wobei das Halogenatom aus Fluoratom und Chloratom ausgewählt ist, und das Polymer für organisches ferroelektrisches Material ein mittleres Molekulargewicht von 10 000 bis 500 000 aufweist, wobei sich das mittlere Molekulargewicht auf ein Gewichtsmittel des Molekulargewichts, das unter Verwendung von Gelfiltrationssäulenchromatographie bestimmt wird, bezieht.

2. Verwendung eines (Meth)acrylat-Polymers nach Anspruch 1, wobei die Anzahl der Kohlenstoffatome des Kohlenwasserstoffgerüstes 2 bis 20 beträgt.

3. Verwendung eines (Meth)acrylat-Polymers nach Anspruch 1 oder 2, wobei das Molekulargewicht der den Hauptmonomereinheiten entsprechenden (Meth)acrylat-Monomere nicht mehr als 500 beträgt.

4. Verwendung eines (Meth)acrylat-Polymers nach einem der Ansprüche 1 bis 3, wobei das Kohlenwasserstoffgerüst ein gesättigtes Kohlenwasserstoffgerüst ist.

5. Verwendung eines (Meth)acrylat-Polymers nach einem der Ansprüche 1 bis 4, wobei die den Hauptmonomereinheiten entsprechenden (Meth)acrylat-Monomere 3,3,3-Trifluorpropyl-(meth)acrylat oder 3,3,3-Trichlorpropyl(meth)acrylat sind.

6. Verwendung eines (Meth)acrylat-Polymers nach einem der Ansprüche 1 bis 5, wobei das (Meth)acrylat-Polymer weiterhin eine oder mehrere andere Arten von (Meth)acrylat-Monomereinheiten als den Hauptmonomereinheiten umfasst.

7. Verwendung eines (Meth)acrylat-Polymers nach einem der Ansprüche 1 bis 6, wobei das (Meth)acrylat-Polymer in Form eines Films vorliegt.

8. Organisches ferroelektrisches Material, bereitgestellt durch Verwendung des (Meth)acrylat-Polymers für organisches ferroelektrisches Material nach Anspruch 7, mit einer Dicke von 10 bis 100 µm, wodurch das organische ferroelektrische Material eine remanente Polarisation aufweist.

9. Organisches ferroelektrisches Material nach Anspruch 8, dessen remanente Polarisation mindestens 100 mC/m² beträgt, wobei die remanente Polarisation bestimmt wird durch Anlegen einer Wechselspannung mit einer Frequenz von 0,001 Hz bis 1 Hz an das organische ferroelektrische Material und Messen der Ansprechladung aus dem organischen ferroelektrischen Material für die Hysterese durch einen Ladungsverstärker.

10. Verwendung eines (Meth)acrylat-Polymers nach einem der Ansprüche 1 bis 6, wobei das Polymer mit einem Vernetzungsmittel vernetzt ist.

11. Verwendung eines (Meth)acrylat-Polymers nach Anspruch 10, wobei das Polymer in Form eines Films vorliegt.

12. Organisches ferroelektrisches Material, bereitgestellt durch Verwendung des Polymers für organisches ferroelektrisches Material nach Anspruch 11, mit einer Dicke von 10 bis 100 µm, wodurch das organische ferroelektrische Material eine remanente Polarisation aufweist.

13. Organisches ferroelektrisches Material nach Anspruch 12, dessen remanente Polarisation mindestens 100 mC/m² beträgt, wobei die remanente Polarisation bestimmt wird durch Anlegen einer Wechselspannung mit einer Frequenz von 0,001 Hz bis 1 Hz an das organische ferroelektrische Material und Messen der Ansprechladung aus dem organischen ferroelektrischen Material für die Hysterese durch einen Ladungsverstärker.

## Revendications

1. Utilisation d'un polymère de (méth)acrylate pour un matériau ferroélectrique organique, dans laquelle le polymère de (méth)acrylate comprend un ou plusieurs types de (méth)acrylates comme unités de monomères principales ayant dans la chaîne latérale un squelette hydrocarbure saturé ou insaturé lié à l'extrémité distale du groupe oxycarbonyle, le squelette d'hydrocarbure ayant
au moins un atome d'hydrogène sur l'atome de carbone β par rapport au groupe oxycarbonyle et
un ou plusieurs groupes retirant les électrons choisis dans le groupe constitué par un atome d'halogène, un groupe cyano, un groupe oxo et un groupe nitro, qui se lient à l'atome de carbone β et/ou à un ou plusieurs atomes de carbone distaux à celui-ci, substituant des atomes d'hydrogène dessus, l'atome d'halogène étant choisi parmi un atome de fluor et un atome de chlore et ledit polymère pour matériau ferroélectrique organique ayant un poids moléculaire moyen de 10 000 à 500 000, ledit poids moléculaire moyen se rapportant à un poids moléculaire moyen en poids qui est déterminé en utilisant une chromatographie sur colonne de filtration de gel.

2. Utilisation d'un polymère de (méth)acrylate selon la revendication 1, dans laquelle le nombre d'atomes de carbone dans le squelette hydrocarbure est de 2 à 20.

3. Utilisation d'un polymère de (méth)acrylate selon la revendication 1 ou 2, dans laquelle le poids moléculaire des monomères (méth)acrylate correspondant aux unités de monomère principales est de pas plus de 500.

4. Utilisation d'un polymère de (méth)acrylate selon l'une des revendications 1 à 3, dans laquelle le squelette hydrocarbure est un squelette hydrocarbure saturé.

5. Utilisation d'un polymère de (méth)acrylate selon l'une des revendications 1 à 4, dans laquelle les monomères de (méth)acrylate correspondant aux unités de monomère principales sont le 3,3,3-trifluoropropyl (méth)acrylate ou le 3,3,3-trichloropropyl (méth)acrylate.

6. Utilisation d'un polymère de (méth)acrylate selon l'une des revendications 1 à 5, le polymère de (méth)acrylate comprenant en outre un ou plusieurs autres types d'unités de monomère (méth)acrylate que les unités de monomère principales.

7. Utilisation d'un polymère de (méth)acrylate selon l'une des revendications 1 à 6, le polymère de (méth)acrylate étant sous la forme d'un film.

8. Matériau ferroélectrique organique fourni en utilisant le polymère de (méth)acrylate pour matériau ferroélectrique organique selon la revendication 7 ayant une épaisseur de 10 à 100 µm, moyennant quoi ledit matériau ferroélectrique organique a une polarisation rémanente.

9. Matériau ferroélectrique organique selon la revendication 8 dont la polarisation rémanente est d'au moins 100 mC/m², dans lequel ladite polarisation rémanente est déterminée en appliquant une tension alternative avec une fréquence de 0,001 Hz à 1 Hz au matériau ferroélectrique organique et en mesurant la charge de réponse du matériau ferroélectrique organique pour l'hystérésis par un amplificateur de charge.

10. Utilisation d'un polymère de (méth)acrylate selon l'une des revendications 1 à 6, dans laquelle le polymère est réticulé avec un agent de réticulation.

11. Utilisation d'un polymère de (méth)acrylate selon la revendication 10, dans laquelle le polymère est sous la forme d'un film.

12. Matériau ferroélectrique organique fourni en utilisant le polymère pour matériau ferroélectrique organique selon la revendication 11 ayant une épaisseur de 10 à 100 µm, moyennant quoi ledit matériau ferroélectrique organique a une polarisation rémanente.

13. Matériau ferroélectrique organique selon la revendication 12 dont la polarisation rémanente est d'au moins 100 mC/m², dans lequel ladite polarisation rémanente est déterminée en appliquant une tension alternative avec une fréquence de 0,001 Hz à 1 Hz au matériau ferroélectrique organique et en mesurant la charge de réponse du matériau ferroélectrique organique pour l'hystérésis par un amplificateur de charge.
